(19) **Europäisches Patentamt / European Patent Office / Office européen des brevets**

(11) **EP 2 825 859 B1**

(12) **EUROPÄISCHE PATENTSCHRIFT**

(45) Veröffentlichungstag und Bekanntmachung des Hinweises auf die Patenterteilung:
**19.10.2022 Patentblatt 2022/42**

(21) Anmeldenummer: **13716726.8**

(22) Anmeldetag: **15.03.2013**

(51) Internationale Patentklassifikation (IPC):
**G01J 5/00** *(2022.01)* **G01J 5/02** *(2022.01)*
**G01J 5/0802** *(2022.01)* **G01J 5/07** *(2022.01)*

(52) Gemeinsame Patentklassifikation (CPC):
**G01J 5/0007; G01J 5/0275; G01J 5/07; G01J 5/0802**

(86) Internationale Anmeldenummer:
**PCT/EP2013/000807**

(87) Internationale Veröffentlichungsnummer:
**WO 2013/135394 (19.09.2013 Gazette 2013/38)**

(54) **VORRICHTUNG ZUM BESTIMMEN DER TEMPERATUR EINES SUBSTRATS**

DEVICE FOR DETERMINING THE TEMPERATURE OF A SUBSTRATE

DISPOSITIF POUR DÉTERMINER LA TEMPÉRATURE D'UN SUBSTRAT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.03.2012 DE 102012005428**

(43) Veröffentlichungstag der Anmeldung:
**21.01.2015 Patentblatt 2015/04**

(73) Patentinhaber:
• **centrotherm international AG**
**89143 Blaubeuren (DE)**
• **HQ-Dielectrics GmbH**
**89156 Dornstadt (DE)**

(72) Erfinder:
• **RICK, Hartmut**
**89160 Dornstadt (DE)**
• **LERCH, Wilfried**
**89160 Dornstadt (DE)**
• **NIESS, Jürgen**
**89567 Sontheim (DE)**

(74) Vertreter: **Klang, Alexander H.**
**Wagner & Geyer Partnerschaft mbB**
**Patent- und Rechtsanwälte**
**Gewürzmühlstrasse 5**
**80538 München (DE)**

(56) Entgegenhaltungen:
**WO-A1-00/47962 WO-A2-2008/003080**
**US-A1- 2002 066 859**

EP 2 825 859 B1

**Beschreibung**

Die vorliegende Erfindung betrifft eine Vorrichtung zum Bestimmen der Temperatur eines Substrats, insbesondere eines Halbleitersubstrats, sowie eine Vorrichtung und ein Verfahren zum thermischen Behandeln von Substraten, insbesondere Halbleitersubstraten.

In der Technik sind unterschiedliche Vorrichtungen und Verfahren zum thermischen Behandeln von Substraten bekannt, sowie Vorrichtungen zum Bestimmen der Temperatur eines Substrats während einer thermischen Behandlung.

Ein bekanntes Verfahren zum thermischen Behandeln von Halbleiterwafern sieht zum Beispiel eine Erwärmung mittels elektromagnetischer Strahlung vor, die von Lampen, beispielsweise Wolfram-Halogenlampen ausgeht. Für eine Temperaturregelung der thermischen Behandlung ist es bekannt, während derselben die Temperatur des Halbleiterwafers über einen auf das Substrat gerichteten Strahlungsmesser zu bestimmen. Da der Strahlungsmesser aber in der Regel nicht nur vom Halbleiterwafer emittierte Strahlung sondern auch am Halbleiterwafer reflektierte Strahlung und gegebenenfalls durch den Halbleiterwafer hindurchgehende Strahlung detektiert, ist eine Unterscheidung dieser Strahlungsanteile für die Temperaturbestimmung erforderlich.

Für eine solche Unterscheidung ist in US 5,318,362 die sogenannte Ripple Technik beschrieben, bei der der Lampenstrahlung über eine entsprechende Ansteuerung eine Frequenz aufgeprägt wird. Diese bestand ursprünglich in der Wechselstromfrequenz der Stromversorgung und über die Zeit wurde die Technik verfeinert und es wurden andere Frequenzen aufgeprägt. Temperaturänderungen des Halbleiterwafers erfolgen im Vergleich zu der aufgeprägten Frequenz wesentlich langsamer. Somit enthält die vom Halbleiterwafer aufgrund seiner Eigentemperatur emittierte Strahlung die der Lampenstrahlung aufgeprägte Frequenz nicht und ist somit von dieser unterscheidbar.

Für eine Temperaturbestimmung mit dieser Technik muß zunächst die Emissivität des Substrats und anschließend die Temperatur bestimmt werden. Der Emissionsgrad eines Objektes kann von der Temperatur oder Prozessreaktionen abhängen und sich im Laufe der thermischen Behandlung allmählich oder sprunghaft ändern, wobei die Änderung reversibel sein kann oder auch nicht. Insbesondere schnelle Änderungen führen bei langsamer oder fehlender Bestimmung zu Störungen der Temperaturbestimmung. Die Kalibrierung einer Emissionsgradmessung ist oft schwierig, da stabile Referenzen fehlen, auch hängt der Emissionsgrad eines Objekts von der Umgebung ab und ist innerhalb des Reaktors anders als außerhalb desselben. Weitere Vorrichtungen zur Bestimmung der Temperatur eines Substrats sind bekannt aus WO 2008/003080 A2, US 2002/0066859 A1 und WO 00/47962.

Der Erfindung liegt daher die Aufgabe zugrunde, eine Vorrichtung und ein Verfahren zum thermischen Behandeln von Substraten bereitzustellen, die bzw. das unabhängig von der Emissivität des Substrats eine auf Strahlung basierende Temperaturbestimmung erlaubt.

Erfindungsgemäß wird diese Aufgabe durch eine Vorrichtung zum Bestimmen der Temperatur von Substraten nach Anspruch 1 und ein Verfahren zum thermischen Behandeln von Substraten nach Anspruch 9 gelöst. Weitere

Ausführungsformen der Erfindung ergeben sich aus den jeweiligen abhängigen Ansprüchen und der Beschreibung.

Vorzugsweise ist wenigstens ein dritter Strahlungsdetektor vorgesehen, der auf wenigstens eine erste Strahlungsquelle gerichtet ist, um die Strahlungsintensität der ersten Strahlungsquelle zu bestimmen.

Bei einer Ausführungsform der Erfindung liegen die ersten und zweiten Oberflächenbereiche im Wesentlichen auf einem gemeinsamen Drehkreis zu einem Mittelpunkt des Substrats. Dabei umfaßt der Begriff im Wesentlichen, dass die Bereiche sich wenigstens im Bereich des gemeinsamen Drehkreises überlappen, auch wenn sie nicht bezüglich des Drehkreises zentriert sind. Hierdurch soll sichergestellt werden, dass die Oberflächenbereiche im Wesentlichen dieselbe Temperatur aufweisen. Dies kann auch dadurch erreicht werden, dass die ersten und zweiten Oberflächenbereiche unmittelbar benachbart zueinander liegen oder sich wenigstens teilweise überlappen.

Vorzugsweise weist die Vorrichtung wenigstens ein optisches Element auf, das den Anteil der am Substrat reflektierten Strahlung der wenigstens einen Strahlungsquelle beeinflußt, wobei das wenigstens eine optische Element beispielsweise eine Blende und/oder ein Filter sein kann. Jedem Strahlungsdetektor kann wenigstens ein optisches Element zugeordnet sein, wobei die optischen Elemente unterschiedliche Öffnungswinkel für ein Sichtfeld des Strahlungsdetektors bilden und/oder mit unterschiedlichen Abständen zum Substrat positioniert sind, um den Anteil der am Substrat reflektierten Strahlung der wenigstens einen Strahlungsquelle am jeweiligen Strahlungsdetektor zu beeinflussen.

Die Vorrichtung kann wenigstens einen Filter aufweisen, der zwischen wenigstens einer Strahlungsquelle aus einer Vielzahl von ersten Strahlungsquellen und dem Substrat angeordnet ist, um aus der Strahlung der wenigstens einen Strahlungsquelle die Strahlung herauszufiltern, die im Bereich der Messwellenlänge des Strahlungsdetektors liegt, bevor die Strahlung der wenigstens einen Strahlungsquelle auf das Substrat fällt.

Bei einer Ausführungsform ist die wenigstens eine erste Strahlungsquelle eine Lampe, insbesondere eine Stablampe.

Bevorzugt werden die ersten und zweiten Strahlungen mit unterschiedlichen Strahlungsdetektoren detektiert, um eine zeitgleiche Detektierung zu ermöglichen. Sie können aber auch abwechselnd mit demselben Strahlungsdetektor detektiert werden.

Für eine kreissymmetrische Homogenisierung der Substrattemperatur wird das Substrat um eine im Wesentlichen senkrecht zur ersten Seite stehenden Achse gedreht, und die ersten und zweiten Oberflächenbereiche liegen im Wesentlichen auf einem gemeinsamen Drehkreis zu einem Mittelpunkt des Substrats. Es ist aber auch - mit oder ohne Drehung des Substrats - möglich, dass die ersten und zweiten Oberflächenbereiche unmittelbar benachbart zueinander liegen oder sich wenigstens teilweise überlappen.

Bei einer Ausführungsform wird der erste und/oder zweite Reflektions-Strahlungsanteil durch wenigstens ein optisches Element zwischen Substrat und einem Strahlungsdetektor zum Detektieren der detektierten Strahlung beeinflußt.

Bei einer Ausführungsform wird im Strahlengang zwischen wenigstens einer Strahlungsquelle aus einer Vielzahl von ersten Strahlungsquellen und dem Substrat Strahlung im Bereich der Messwellenlänge des Strahlungsdetektors herausgefiltert, die im Bereich der Messwellenlänge des Strahlungsdetektors liegt, bevor die Strahlung der wenigstens einen Strahlungsquelle auf das Substrat fällt, um dadurch den detektierten Reflektions-Strahlungsanteil zu beeinflussen.

Vorzugsweise wird mit einem Strahlungsdetektor, der auf die wenigstens eine erste Strahlungsquelle gerichtet ist, die von der wenigstens einen Strahlungsquelle kommende Strahlungsintensität detektiert, wobei das Ergebnis dieser Detektion in die Ermittlung der Temperatur des Substrats eingeht.

Die Erfindung wird nachfolgend anhand der Zeichnungen näher beschrieben. In den Zeichnungen zeigt:

Fig. 1 eine schematische Seitenschnittansicht durch eine Vorrichtung zum thermischen Behandeln von Halbleiterwafern;

Fig. 2 eine schematische Draufsicht auf einen Halbleiterwafer;

Fig. 3 (a) bis (c) schematische Seitenansichten unterschiedlicher Anordnungsvarianten für Substratpyrometer bezüglich einer Lampenbank;

Fig. 4 (a) eine Kurve, die den erwarteten Verlauf eines Pyrometersignals in Abhängigkeit von der Temperaturstrahlung des Wafers zeigt;

Fig. 4 (b) eine Kurve, die den erwarteten Verlauf eines Pyrometersignals in Abhängigkeit von der Ansteuerleistung von Heizlampen zeigt, deren emittierte Strahlung über eine Reflektion an einem Wafer in das Pyrometer gelangt;

Fig. 5(a) und 5(b) eine Kurve, die den erwarteten Verlauf eines Pyrometersignals in Abhängigkeit von der Temperatur eines Wafers zeigt, wobei das Pyrometer sowohl Temperaturstrahlung des Wafers als auch am Wafer reflektierte Strahlung von Heizlampen die mit konstanter Lampenleistung angesteuert werden, detektiert, wobei Fig. 5(a) den erwarteten Verlauf des Pyrometersignals bei einer Lampenleistung von 5% zeigt und Fig. 5(b) den erwarteten Verlauf des Pyrometersignals bei einer Lampenleistung von 50% zeigt;

Fig. 6 eine Kurve, die erwartete Arbeitstemperaturen eines Pyrometers als eine Funktion der Lampenleistung zeigt; und

Fig. 7 unterschiedliche Kurven, die erwartete Arbeitstemperaturen eines Pyrometers als eine Funktion der Lampenleistung zeigen, wobei die unterschiedlichen Kurven auf der Detektierung von unterschiedlichen Anteilen von reflektierter Strahlung der Heizlampen am Pyrometer basieren.

In der nachfolgenden Beschreibung verwendete Bezeichnungen wie oben, unten, links und rechts und ähnliches, beziehen sich auf die Figuren und sollen in keiner Weise einschränkend sein, obwohl sie sich auf eine bevorzugte Ausführungsform beziehen. Die Formulierung "im Wesentlichen", bezogen auf Winkel und Anordnungen, soll Abweichungen bis 10° vorzugsweise bis 5° umfassen, sofern nicht andere Angaben gemacht sind. Die Formulierung "im Wesentlichen", bezogen auf andere Angaben, soll Abweichungen bis 10% vorzugsweise bis 5% umfassen, sofern nicht andere Angaben gemacht sind.

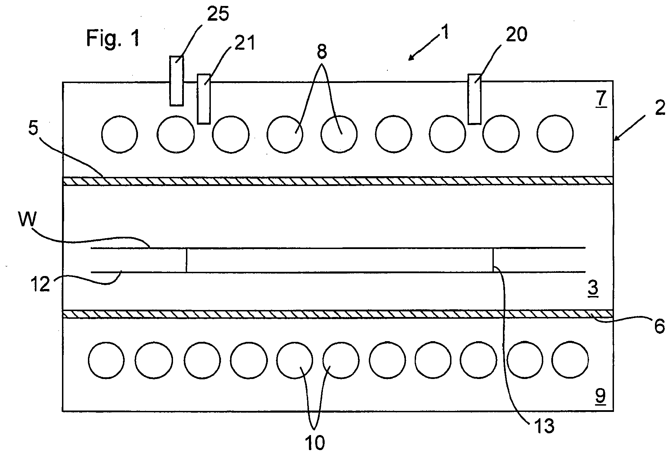

Fig. 1 zeigt eine schematische Seitenschnittansicht einer Vorrichtung 1 zum thermischen Behandeln von Halbleiterwafern W. Die Vorrichtung 1 weist ein Gehäuse 2 mit einem Innenraum auf, der unter anderem eine Prozesskammer 3 bildet. Die Prozesskammer 3 ist auf ihrer Ober- und Unterseite durch Wandelemente 5 bzw. 6 begrenzt und seitlich durch das Gehäuse 2. Oberhalb des Wandelements 5 ist im Gehäuse 2 eine Lampenkammer 7 vorgesehen, die verspiegelt sein kann und in der eine Heizquelle in der Form von mehreren Lampen 8 vorgesehen ist. Unterhalb des Wandelements 6 ist ebenfalls eine Lampenkammer 9 ähnlich der Kammer 7 vorgesehen, in der eine Heizquelle in der Form von mehreren Lampen 10 vorgesehen ist.

Die Seitenwände der Prozesskammer 3 können ebenfalls eine gewisse Spiegelwirkung für wenigstens einen Teil der in der Prozesskammer 3 vorhandenen elektromagnetischen Strahlung aufweisen. Ferner umfasst wenigstens eine der Seitenwände der Prozesskammer 3 eine nicht dargestellte Prozesskammertür, um das Einführen und Herausnehmen des Halbleiterwafers W zu ermöglichen. Ferner können nicht näher dargestellte Gaseinlässe und Gasauslässe für die Prozesskammer 3 vorgesehen sein.

Innerhalb der Prozesskammer 3 ist eine Substrathalterung 12 mit Auflagen 13 vorgesehen, auf denen der Halbleiterwafer W abgelegt ist. Die Substrathalterung 12 ist mit einem Rotationsmechanismus verbunden, um einen aufgenommenen Halbleiterwafer W um eine im Wesentlichen Senkrecht zur Oberseite des Halbleiterwafers W stehende Achse zu drehen. Hierdurch soll, wie es in der Technik bekannt ist, ein Ausgleich von Temperaturunterschieden auf dem Halbleiterwafer erreicht werden. In der Prozesskammer 3 kann ein den Halbleiterwafer in seiner Ebene radial umgebender Kompensationsring vorgesehen sein, wie es in der Technik bei RTP-Anlagen bekannt ist.

Die Wandelemente 5 und 6, welche die Prozesskammer 3 nach oben und unten begrenzen, bestehen jeweils aus Quarz und sind für die Strahlung der Lampen 8 bzw. 10 im Wesentlichen transparent.

Die Lampen 8 und 10 können sogenannte Flash-Lampen, die in der Regel im Blitzbetrieb betrieben werden, oder auch Wolfram-Halogenlampen sein, die üblicherweise im Dauerbetrieb betrieben werden. Diese Lampen können natürlich auch anders angeordnet sein und insbesondere ist es auch möglich, die Lampentypen miteinander oder auch mit anderen Lampentypen zu kombinieren. Insbesondere ist es auch möglich, auf die untere Lampenkammer 9 und die Lampen 10 zu verzichten und nur eine obere Lampenkammer 7 mit Lampen 8 vorzusehen, bzw. auf die obere Lampenkammer 7 und die Lampen 8 zu verzichten und nur eine untere Lampenkammer 9 mit Lampen 10 vorzusehen.

Die Vorrichtung 1 weist ferner ein erstes, auf die Oberseite des Halbleiterwafers W gerichtetes Pyrometer auf, das nachfolgend als erstes Substratpyrometer 20 bezeichnet wird, sowie ein zweites, auf die Oberseite des Halbleiterwafers W gerichtetes Pyrometer, das nachfolgend als zweites Substratpyrometer 21 bezeichnet wird. Ferner ist auch ein drittes auf wenigstens eine der Lampen 8 gerichtetes Pyrometer vorgesehen, das nachfolgend als Lampenpyrometer 25 bezeichnet wird. Optional kann auch ein auf die Rückseite des Halbleiterwafers W gerichtetes Pyrometer, d.h. ein Pyrometer, das auf eine den Lampen 8 gegenüberliegenden Seite des Halbleiterwafers W gerichtet ist, vorgesehen sein, um eine Transmission des Halbleiterwafers W berücksichtigen zu können.

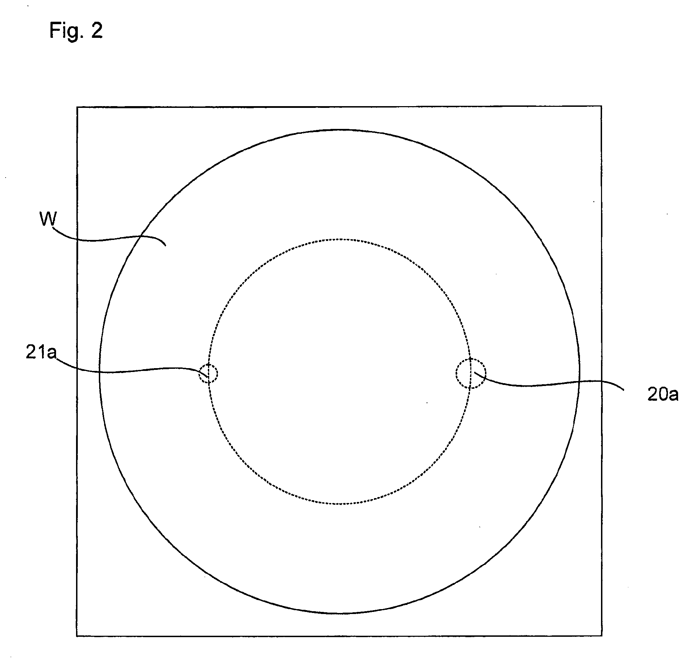

Das erste Substratpyrometer 20 und das zweite Substratpyrometer 21 sind derart auf die Oberseite des Halbleiterwafers W gerichtet, dass sie auf Oberflächenbereiche 20a, 21a mit gleicher Temperatur gerichtet sind. Bei einem sich drehenden Halbleiterwafer W können die ersten und zweiten Oberflächenbereiche 20a, 21a im Wesentlichen auf einem gemeinsamen Drehkreis zu einem Mittelpunkt des Halbleiterwafers W liegen. Dabei soll der Begriff im Wesentlichen ein wenigstens teilweises Überlappen der Oberflächenbereiche 20a, 21a in Drehrichtung umfassen. Eine solche Anordnung ist beispielsweise in der Ansicht gemäß Fig. 2 erkennbar. Die Oberflächenbereiche 20a, 21a könnten aber auch unmittelbar benachbart oder einander überlappend angeordnet sein und dadurch sicherstellen, dass der Halbleiterwafer W in den Oberflächenbereichen 20a, 21a die gleiche Temperatur aufweist.

Bei der Darstellung gemäß Fig. 1 sind das erste Substratpyrometer 20 und das zweite Substratpyrometer 21 so dargestellt, dass sie sich in die obere Lampenkammer hinein erstrecken und senkrecht von oben auf den Halbleiterwafer W gerichtet sind. Es wäre aber auch möglich, die ersten und zweiten Substratpyrometer seitlich am Gehäuse 2 anzubringen und von der Seite her auf den Halbleiterwafer W zu richten. Beispielsweise könnten die ersten und zweiten Substratpyrometer 20, 21 auch über einen Lichtwellenleiter, der sich in abgeschirmter Weise in oder durch die Lampenkammer 7 und eine entsprechende Öffnung in der oberen Wand 5 erstreckt, auf die Oberseite des Halbleiterwafers W gerichtet sein.

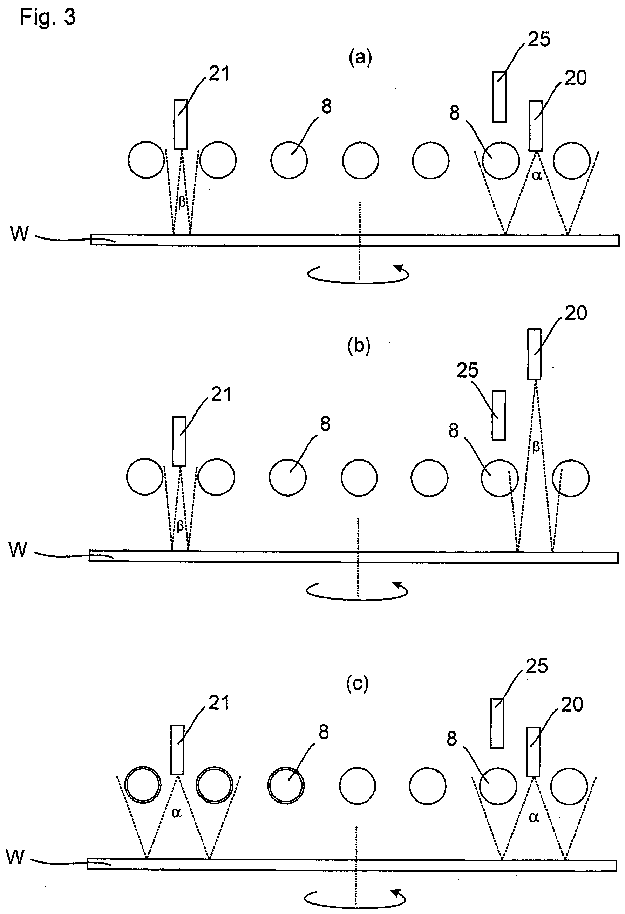

Die ersten und zweiten Substratpyrometer 20, 21 sind somit in der Lage, vom Halbleiterwafer W kommende Strahlung zu detektieren. Diese vom Substrat kommende Strahlung enthält vom Substrat emittierte Strahlung, die nachfolgend als Substrat-Strahlung bezeichnet wird, sowie in der Regel von den Lampen 8 stammende, am Halbleiterwafer W reflektierte Strahlung, die nachfolgend als Reflektions-Strahlung bezeichnet wird. Die an den jeweiligen ersten und zweiten Substratpyrometern 20, 21 detektierte Strahlung unterscheidet sich hinsichtlich der Zusammensetzung der Anteile der Substrat-Strahlung und der Reflektions-Strahlung. Dies kann auf unterschiedliche Arten und Weisen erreicht werden, wie nachfolgend unter Bezugnahme auf Fig. 3, noch näher erläutert wird. Dabei ist es möglich, dass der Anteil der Reflektions-Strahlung, der an einem der Substratpyrometer 20, 21 gemessen wird null ist, oder gegen null geht.

Bei der Darstellung gemäß Fig. 1 ist das Lampenpyrometer 25 so dargestellt, dass es sich in die obere Lampenkammer hinein erstrecken und senkrecht von oben auf eine der Lampen 8 der oberen Lampenbank gerichtet ist. Es wäre aber auch möglich, das Lampenpyrometer 25 seitlich am Gehäuse 2 anzubringen und von der Seite her auf eine der Lampen 8 zu richten.

Die Figuren 3a bis c zeigen schematische Seitenansichten unterschiedlicher Anordnungsvarianten der Substratpyrometer 20, 21 und des Lampenpyrometers 25 bezüglich des Halbleiterwafers W und den Lampen 8 der oberen Lampenbank.

Bei allen Anordnungsvarianten sind die Substratpyrometer 20, 21 zwischen benachbarten Lampen 8 der oberen Lampenbank hindurch auf die Oberseite des Halbleiterwafers W gerichtet. Dabei sind die Substratpyrometer 20, 21 jeweils so angeordnet, dass sie im Wesentlichen keine direkt von den Lampen 8 kommende Strahlung detektieren können, was zum Beispiel über eine entsprechende Öffnung einer Blende der Substratpyrometer 20, 21 erreicht werden kann. In den unterschiedlichen Anordnungsvarianten ist jeweils das Sichtfeld der Substratpyrometer 20, 21 durch gestrichelte Linien angedeutet.

In allen Anordnungsvarianten ist ferner das Lampenpyrometer 25 jeweils auf eine Lampe 8 gerichtet, und zwar benachbart zum Substratpyrometer 20, so dass das Lampenpyrometer 25 die Strahlung einer Lampe 8 detektierten kann, welche über Reflektion auch durch das Substratpyrometer 20 detektiert wird, wie nachfolgend noch näher erläutert wird.

Bei der Anordnungsvariante gemäß Fig. 3a besitzt das Substratpyrometer 20 ein Sichtfeld auf dem Halbleiterwafer W, das durch einen Öffnungswinkel α und den Abstand des Substratpyrometers 20 zum Halbleiterwafer W definiert wird. Der Öffnungswinkel α ist bei der Position des Substratpyrometers 20 derart gewählt, dass eine einfach reflektierte Strahlung der Lampen 8, die benachbart zum Substratpyrometer 20 angeordnet sind, in das Substratpyrometer 20 fällt und hierdurch detektiert wird.

Das Substratpyrometer 21 besitzt ein Sichtfeld auf dem Halbleiterwafer W, das durch einen Öffnungswinkel β und den Abstand des Substratpyrometers 21 zum Halbleiterwafer W definiert wird. Der Öffnungswinkel β ist so gewählt, dass bei der Position des Substratpyrometers 21 keine Strahlung der Lampen 8 mittels einfacher Reflektion in das Substratpyrometer 21 einfallen kann. Bei der Erklärung der obigen Anordnungsvariante wurden nur Einfachreflektionen der Lampenstrahlung berücksichtigt. Natürlich können in jedes der Substratpyrometer 20, 21 über Mehrfachreflektionen (weitere) Lampenstrahlung in das entsprechende Substratpyrometer 20, 21 einfallen. Diese können aber nachfolgend im Wesentlichen vernachlässigt werden, da der entsprechende Anteil der Strahlung, der über Mehrfachreflektionen in das Substratpyrometer 20 oder 21 fällt, relativ gering ist.

Wie sich aus der obigen Erklärung und der Figur 3a ergibt, werden an den Substratpyrometern 20, 21 im Wesentlichen die gleiche Substrat-Strahlung gemessen, jedoch unterschiedliche Anteile der Reflektions-Strahlung. An dem Substratpyrometer 21 wird im Wesentlichen keine oder nur ein sehr geringer Anteil an Reflektionsstrahlung gemessen, während am Substratpyrometer 20 in Abhängigkeit von der Intensität der Lampen 8 ein erheblicher Anteil gemessen werden kann.

Bei der Anordnungsvariante gemäß Fig. 3b besitzen die Substratpyrometer 20, 21 jeweils ein Sichtfeld auf dem Halbleiterwafer W das durch einen gleichen Öffnungswinkel β und unterschiedlich große Abstände der Substratpyrometer 20, 21 zum Halbleiterwafer W definiert wird. Das Substratpyrometer 20 ist mit einem größeren Abstand bezüglich der Oberfläche des Halbleiterwafers W angeordnet als das Substratpyrometer 21. Hierdurch ist es möglich, dass Strahlung der Lampen 8 mittels Einfachreflektion in das Substratpyrometer 20 einfällt, während dies bei dem Substratpyrometer 21 nicht der Fall ist, wie in Fig. 3b dargestellt ist. Somit ist es wiederum möglich, dass an den Substratpyrometer 20, 21 zwar dieselbe Substrat-Strahlung, aber unterschiedliche Anteile der Reflektions-Strahlung detektiert werden.

Fig. 3c zeigt eine weitere Anordnungsvariante der Substratpyrometer 20, 21. Bei dieser Anordnungsvariante besitzen die Substratpyrometer 20, 21 jeweils ein Sichtfeld auf dem Halblweiterwafer W, das durch gleiche Öffnungswinkel α und gleiche Abstände der Substratpyrometer 20, 21 zum Halbleiterwafer definiert wird. Somit würden jeweils gleiche Anteile an Reflektions-Strahlung in das entsprechende Substratpyrometer 20, 21 einfallen. Im Bereich des Substratpyrometers 21 sind die Lampen 8 jedoch von einem Filterelement umgeben, dass Lampenstrahlung im Bereich der Messwellenlänge des Substratpyrometers 21 herausfiltert. Somit fällt zwar grundsätzlich Reflektions-Strahlung der Lampen 8 in das Substratpyrometer 21 ein, diese Strahlung liegt aber außerhalb des Messwellenbereichs des Substratpyrometers 21, so dass das Substratpyrometer 21 einen unterschiedlichen Anteil an Reflektions-Strahlung detektiert als das Substratpyrometer 20.

Im Betrieb kann eine an die Substratpyrometer 20, 21 und das Lampenpyrometer angeschlossene, nicht näher dargestellte Auswerteschaltung aus den detektierten Strahlungen direkt die Temperatur des Halbleiterwafers W bestimmen, wie nachfolgend noch näher erläutert wird. Ferner kann aus den detektierten Strahlungen auch die Emissivität des Halbleiterwafers W bestimmt werden.

Während des Betriebs wird der Halbleiterwafer W über die Lampen 8 und gegebenenfalls die Lampen 10 erwärmt. Die Substratpyrometer 20, 21 detektieren die vom Halbleiterwafer W kommende Strahlung, die wie oben erklärt die Substrat-Strahlung und gegebenenfalls die Reflektions-Strahlung enthält. Darüber können in der detektierten Strahlung auch Transmissionskomponenten enthalten sein, die aber bei der folgenden Beschreibung nicht berücksichtigt werden. Das Lampenpyrometer 25 detektiert die Lampenstrahlung wenigstens einer Lampe 8. Diese Lampenstrahlung kann optional in bekannter Weise eine Modulation aufweisen, um sie von Substrat-Strahlung unterscheiden zu können. Eine solche Modulation ist für eine Temperaturbestimmung nicht unbedingt notwendig, sie kann aber gegebenenfalls zusätzliche Information vorsehen.

Die übliche pyrometrische Temperaturmessung basiert auf der Messung der Intensität der thermischen Strahlung eines Gegenstandes bei einer vorbestimmten Wellenlänge. Für einen schwarzen Strahler mit der Temperatur $T$ ist die thermische Strahlungsleistung $P_{bb}$, die vom Flächenelement $dA$ im Wellenlängenbereich zwischen $\lambda$ und $\lambda + d\lambda$ in den gesamten Halbraum abgestrahlt wird, durch die Plancksche Formel gegeben:

$$\frac{dP_{bb}(T,\lambda)}{dAd\lambda} = \frac{C_1}{\lambda^5 (e^{c_2/(\lambda T)} - 1)}$$

wobei

$$C_1 = 2\pi hc^2 = 3{,}742 * 10^8 \frac{\mathrm{W}\mu\mathrm{m}^4}{\mathrm{m}^2}$$

und

$$C_2 = \frac{hc}{k} = 14388\,\mu\mathrm{mK} \ .$$

Für ein reales Objekt ist die Strahlung kleiner als die eines schwarzen Strahlers:

$$\frac{dP(T,\lambda)}{d\lambda} = \varepsilon(T,\lambda)\frac{dP_{\mathrm{bb}}(T,\lambda)}{dAd\lambda} \ ,$$

wobei $\varepsilon$ mit $0 < \varepsilon < 1$ die Emissivität des Objekts darstellt. Diese ist von der Wellenlänge und dem Blickwinkel abhängig und ändert sich häufig auch mit der Temperatur des Objekts. Darüber hinaus ist sie auch situationsabhängig, so ist die Emissivität eines Objekts in einer reflektierenden Kammer beispielsweise höher als im freien Raum.

Für eine Temperaturmessung eines Objekts anhand seiner Strahlung bei einer Wellenlänge müssen daher üblicherweise die Emissivität des Objekts bei der Wellenlänge und der Blickwinkel auf das Objekt bekannt sein. Die direkte Emissivität bei einer Wellenlänge ist gemäß dem Kirchhoffschen Gesetz dieselbe wie die direkte Absorption bei der Wellenlänge, sodass $\varepsilon = 1 - \rho - \tau$ gilt, wobei $\rho$ die Reflektivität und $\tau$ die Transmissivität ist.

Bei der Vorrichtung des zuvor beschriebenen Typs wird an dem Substratpyrometer 20 sowohl Substrat-Strahlung als auch Reflektions-Strahlung gemessen. Davon ausgehend, dass keine direkte Lampenstrahlung in das Substratpyrometer einfallen kann, Mehrfachreflektionen nicht berücksichtigt werden und keine Transmission bei der Messwellenlänge des Substratpyrometers 20 auftritt, dann kann das Signal $S_{20}$ des Substratpyrometers 20 wie folgt dargestellt werden:

$$S_{20} = a\varepsilon P_{bb}(\mathrm{T}) + b\rho L(P) \ ,$$

wobei $P_{bb}(T)$ die Schwarzkörperstrahlung entsprechend der Wafertemperatur $T$ gemäß der Planckschen Formel ist, $\varepsilon$ die Emissivität der Waferoberfläche ist, und $L(P)$ die Lampenstrahlung bei der Messwellenlänge ist, wenn die Lampen mit einer vorgegebenen Leistung $P$ betrieben werden. $\rho$ ist die Reflektivität der Waferoberfläche und $a$ und $b$ sind Konstanten, die vom Sichtfeld des Pyrometers, der Kammergeometrie und anderen Parametern abhängen.

Ohne Transmissivität ist die Reflektivität $\rho = 1 - \varepsilon$, so dass das Pyrometersignal wie folgt dargestellt werden kann:

$$S_{20} = a\varepsilon P_{bb}(T) + b(1 - \varepsilon)L(P) = (aP_{bb}(T) - bL(P))\varepsilon + bL(P)$$

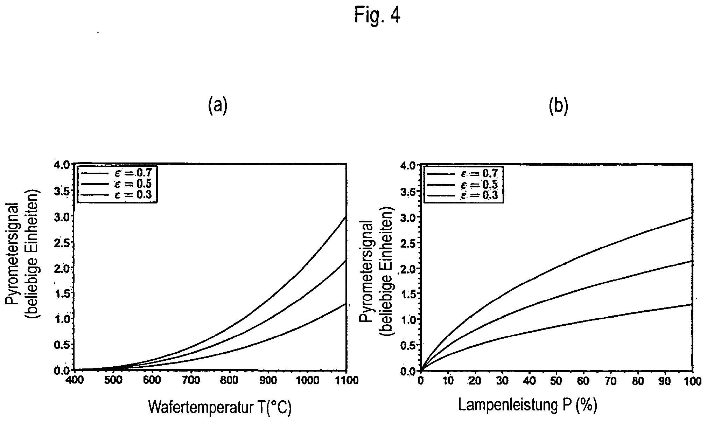

Wenn man in der oben genannten Vorrichtung davon ausgeht, dass die Lampen 8 Wolfram-Halogen Lampen sind und das Substratpyrometer eine Messwellenlänge von 2,3 $\mu$m aufweist, dann kann der Einfluß der Substrat-Strahlung und der Reflektions-Strahlung im Signal des Substratpyrometers wie in den Figuren 4(a) und 4(b) dargestellt werden. Dabei zeigt Fig. 4(a) den Verlauf des Pyrometersignals in Abhängigkeit von der Temperatur des Wafers für die reine Substrat-Strahlung (Lampen aus) und Fig. 4(b) den Verlauf des Pyrometersignals in Abhängigkeit von der Lampenleistung in % für die reine Reflektions-Strahlung (Wafertemperatur = 0). Beide Figuren 4(a) und 4(b) zeigen den Verlauf jeweils für unterschiedliche Emissivitäten $\varepsilon$ eines Halbleiterwafers W.

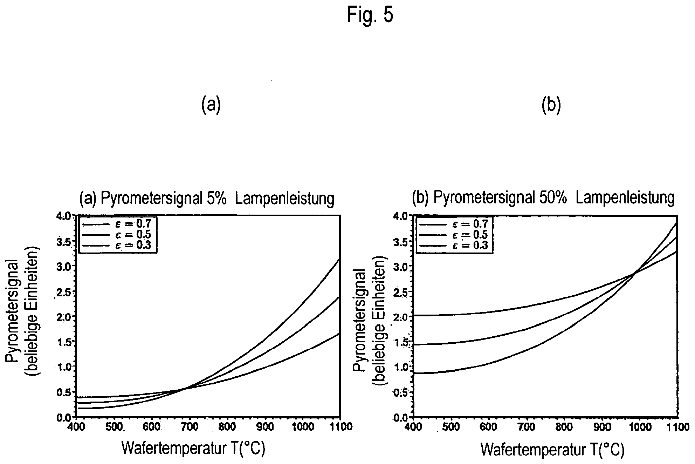

Die Figuren 5(a) und 5(b) zeigen den erwarteten Verlauf des Pyrometersignals in Abhängigkeit von der Temperatur des Wafers mit sowohl der Substrat-Strahlung als auch der Reflektions-Strahlung. Dabei zeigt Fig. 5(a) den erwarteten Verlauf des Pyrometersignals bei einer Lampenleistung von 5% und Fig. 5(b) den erwarteten Verlauf des Pyrometersignals bei einer Lampenleistung von 50%, und zwar jeweils für unterschiedliche Emissivitäten $\varepsilon$ eines Halbleiterwafers W.

Wie an den Kreuzungspunkten der Kurven in den Figuren 5(a) und 5(b) zu erkennen ist, gibt es für jede Lampenleistung eine Wafertemperatur, bei der das Pyrometersignal unabhängig von der Emissivität $\varepsilon$ des Halbleiterwafers W ist. Diese Kreuzungspunkte definieren eine Arbeitstemperatur eines Pyrometers und die Temperatur kann wie folgt dargestellt werden:

$$aP_{bb}(T_P(P)) = bL(P)$$

Bei dieser Temperatur ist das Pyrometersignal:

$$S = bL(P) = aP_{bb}(T_P(P))$$

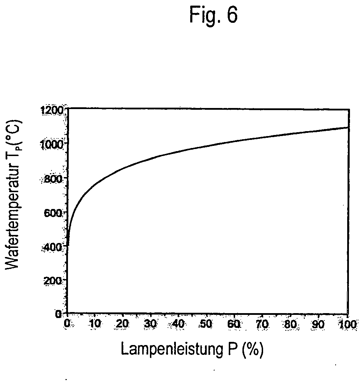

Fig. 6 zeigt nun eine Kurve von Arbeitstemperaturen eines Pyrometers als eine Funktion der Lampenleistung. Jedesmal, wenn die Wafertemperatur diese Kurve bei einer entsprechenden Lampenleistung $P$ überquert, ist die Temperatur ohne Kenntnis der Emissivität $\varepsilon$ des Halbleiterwafers direkt bekannt.

Dabei ist in der Praxis die Lampenleistung $P$ nicht diejenige, die den Halbleiterwafer W auf einer konstanten Temperatur $T_P$ hält. Es wären also unterschiedliche Lampenleistungen für eine Prozeßführung einerseits und eine Messung andererseits zweckmäßig. So wäre es möglich, für eine Messung die Lampenleistung rasch kontinuierlich zu verändern. Hierdurch könnte der Punkt ermittelt werden, bei dem die Lampenleistung und das Pyrometersignal mit der Linie gemäß Fig. 6 übereinstimmen, was eine direkte Temperaturbestimmung erlaubt. Anschließend könnte die Lampenleistung wieder für eine normale Prozeßführung geregelt werden. Sofern ein solches Verändern der Lampenleistung rasch genug möglich ist, ohne die Temperatur des Halbleiterwafers zu beeinflussen, wäre eine direkte Temperaturmessung mit nur einem Substratpyrometer möglich.

Bevorzugt werden aber beide der oben beschriebenen Substratpyrometer 20, 21 für eine Temperaturmessung eingesetzt, wobei die unterschiedlichen Anteile an gemessener Reflektions-Strahlung die direkte Temperaturmessung ermöglichen, wie nachfolgend beschrieben wird.

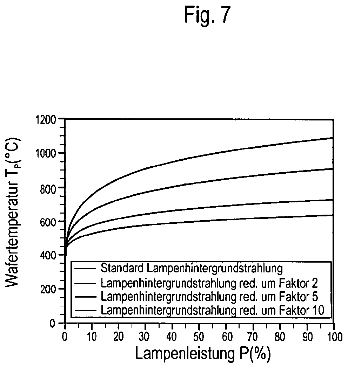

Figur 7 zeigt unterschiedliche Kurven der Arbeitstemperatur (entsprechend Fig. 6) eines Pyrometers für unterschiedliche Anteile der Reflektions-Strahlung bei gleichbleibender Substrat-Strahlung. Die oberste Kurve zeigt die Arbeitstemperatur für die normale zu erwartende Reflektions-Strahlung. Die niedrigeren Kurven entsprechen einer Reduktion der erwarteten Reflektions-Strahlung um den Faktor 2, 5 bzw. 10.

Zwei Substratpyrometer, die bei gleichbleibender Substrat-Strahlung unterschiedliche Anteile an Reflektions-Strahlung detektieren, ermöglichen eine direkte Temperaturbestimmung auf den unterschiedlichen Kurven der entsprechenden Arbeitstemperaturen. Ferner kann eine gewichtete Summe von zwei Pyrometersignalen, die in bekannter Weise unterschiedliche Anteile an Reflektions-Strahlung enthalten, verwendet werden, um ein virtuelles Pyrometer zu emulieren, das einen Arbeitspunkt bei der derzeitigen Wafertemperatur besitzt.

Mathematisch können die Pyrometersignale der Substratpyrometer 20, 21 wie folgt ausgedrückt werden:

$$S_{20} = a_{20}\varepsilon P_{bb}(T) + b_{20}(1 - \varepsilon)L(P)$$

und

$$S_{21} = a_{21}\varepsilon P_{bb}(T) + b_{21}(1 - \varepsilon)L(P)$$

Dabei ist $S_{20}$ das Pyrometersignal des Substratpyrometers 20, $a_{20}$ eine Konstante, die einen Verstärkungsfaktor der Waferstrahlung am Substratpyrometer 20 berücksichtigt, und $b_{20}$ eine Konstante, die einen Einfluss der Reflektions-Strahlung am Substratpyrometer 20 berücksichtigt. Entsprechend ist $S_{21}$ das Pyrometersignal des Substratpyrometers 21, $a_{21}$ eine Konstante, die einen Verstärkungsfaktor der Waferstrahlung am Substratpyrometer 21 berücksichtigt, und $b_{21}$ eine Konstante, die einen Einfluss der Reflektions-Strahlung am Substratpyrometer 21 berücksichtigt. Der Einfluß der Reflektions-Strahlung wird durch die Anteile aus Substrat-Strahlung und Reflektions-Strahlung bestimmt, die sich ja bekanntlich bei den Substratpyrometern unterscheiden.

Eine Auflösung der obigen Gleichungen ergibt nun:

$$P_{bb}(T) = \frac{(b_{21}S_{20} - b_{20}S_{21})L(P)}{a_{21}S_{20} - a_{20}S_{21} + (a_{20}b_{21} - a_{21}b_{20})L(P)}$$

und

$$\varepsilon = 1 - \frac{a_{21}S_{20} - a_{20}S_{21}}{(a_{21}b_{20} - a_{20}b_{21})L(P)} \; .$$

Für diese Gleichungen besteht immer eine Lösung, solange beide Substratpyrometer ein Signal ungleich null und unterschiedliche Anteile der Reflektions-Strahlung detektieren. Dabei ist die berechnete Emissivität eine In-Situ Emissivität, die nur innerhalb der Kammer und innerhalb des linearen Models gilt.

In der Realität werden die Pyrometersignale $S_{20}$ und $S_{21}$ noch durch andere Faktoren beeinflusst, die in der obigen Gleichung nicht dargestellt sind. Ferner können Mehrfachreflektionen der Lampenstrahlung, die in das Pyrometer fallen, ebenfalls die Gleichung beeinflussen. Auch ist die einfache Beziehung zwischen Lampenleistung und erwarteter Lampenstrahlung bei sich rasch ändernder Lampenleistung nicht unbedingt genau. Daher kann es zweckmäßig sein, die Lampenstrahlung direkt zu ermitteln, was über das Lampenpyrometer 25 erreicht werden kann. Statt der Lampenleistung kann dann die Messung des Lampenpyrometers in die obigen Gleichungen eingehen. Diese Messung kann gegebenenfalls auch noch durch ein Modell, das auf der Lampenleistung basiert, unterstützt werden, um Einflüsse von weiter entfernten Lampen zu berücksichtigen.

Die Kurven der Arbeitstemperaturen gemäß Fig. 6 basieren auf einem einfachen Modell, und die tatsächlichen Kurven werden von den dargestellten abweichen. Statt das Modell zu verbessern, kann es zweckmäßig sein, die Kurven im Rahmen einer Kalibrierungsroutine zu ermitteln. Hierzu sind unterschiedliche Kalibrierungsläufe mit wenigstens zwei Wafern mit unterschiedlichen Emissivitäten erforderlich. Ein Kalibrierungslauf besteht aus einer Sequenz von unterschiedlichen konstanten Lampenleistungen oder bevorzugt konstanter Lampenstrahlung die durch das Lampenpyrometer gemessen wird.

Konstante Lampenleistung/-strahlung führt dazu, dass der Wafer sich asymptotisch einer Gleichgewichtstemperatur annähert. Diese ist für hohe Lampenleistung/-strahlung höher als die Arbeitstemperatur des Pyrometers und für niedrigere Lampenleistung/-strahlung niedriger als die Arbeitstemperatur des Pyrometers. Wenn man nun bei niedriger Wafertemperatur mit hoher Lampenleistung/-strahlung anfängt, dann wird die Wafertemperatur die Kurve gemäß Fig. 6 überqueren. Eine Reduzierung der Lampenleistung/-strahlung führt nun dazu dass die Wafertemperatur unter die Kurve gemäß Fig. 6 abfällt. Es kann eine Sequenz eingestellt werden, bei der die Temperatur die Kurve mehrfach an unterschiedlichen Positionen kreuzt, um die gesamte Kurve zu erhalten. Wenn diese Sequenz mit beiden Wafern (mit unterschiedlichen Emissivitäten) gefahren wird, läßt sich die wahre Position der Kurve der Arbeitstemperaturen ermitteln.

Diese Kalibrierung kann für beide Substratpyrometer erfolgen, sofern diese unterschiedliche Arbeitstemperaturen besitzen. Wie zuvor erwähnt, wird die tatsächliche Temperatur eines Wafers selten auf einer der kalibrierten Kurven der Arbeitstemperaturen liegen, es kann aber ein virtuelles Pyrometer $S_v$ aus einer gewichteten Summe der zwei Pyrometersignale emuliert werden:

$$S_v = \alpha S_{20} + (1-\alpha)S_{21}$$

Für jedes virtuelle Pyrometer, das durch den Wert von $\alpha$ bestimmt wird, kann eine entsprechende Kalibrierung der Kurve der Arbeitstemperatur durchgeführt werden und zwar in einer entsprechenden Art und Weise, wie sie für die realen Pyrometer durchgeführt wurden. Dies scheint für eine begrenzte Anzahl von virtuellen Pyrometern auch zweckmäßig. Für tatsächliche Temperaturmessungen können die nicht abgedeckten Temperaturwerte dann durch eine Interpolation der Kurven der Arbeitstemperaturen erhalten werden.

Die Erfindung wurde anhand bevorzugter Ausführungsformen der Erfindung erläutert, ohne auf diese Ausführungsformen beschränkt zu sein. Beispielsweise könnten auch mehr als zwei Substratpyrometer eingesetzt werden oder es könnte ein einzelnes Substratpyrometer verwendet werden, wobei beispielsweise über eine bewegliche Blende ständig in bekannter Weise das Sichtfeld auf dem Halbleiterwafer und somit der Anteil einer Reflektions-Strahlung, die in das Substratpyrometer fällt, verändert wird. Hierdurch werden zwei Pyrometer mit unterschiedlichen Anteilen an Reflektions-Strahlung simuliert. Man könnte auch zwei Pyrometer vorsehen, die aus unterschiedlichen Positionen auf dieselbe Stelle des Substrats gerichtet sind, so dass eines der Pyrometer das auf der Substratoberfläche gespiegelte Bild einer Lampe sieht, das andere aber nicht. In 3 Dimensionen kann man das auch bei gleichem Öffnungswinkel und gleichem Einfallswinkel auf der Substratoberfläche erreichen. Die beiden Oberflächenbereiche des Substrats können in dem Fall exakt übereinstimmen, so dass jedenfalls sichergestellt ist, dass sie beide dieselbe Temperatur und denselben Emissionsgrad haben, auch ohne Rotation. Bei einer weiteren Anordnungsvariante könnte eines der Pyrometer durch eine Röhre, die optional zumindest teilweise reflektierend sein kann, auf das Substrat gerichtet, sein, wobei sich die Röhre bis kurz vor die Substratoberfläche erstrecken kann. Bei geeignetem (schmalen) Öffnungswinkel des Pyrometers wird dadurch das Pyrometer optisch näher an das Substrat gerückt. Ein Pyrometer mit Röhre und eines ohne Röhre, z.B. auf einem gemeinsamen Drehkreis, ergeben dann wieder die benötigte Kombination von unterschiedlichen Reflektionsbeiträgen.

Weiterhin kann zum Beispiel auch eine Vorrichtung gebildet werden, die Anordnungsvarianten der Substratpyrometer mit unterschiedlichen Öffnungswinkeln, unterschiedlichen Abständen zum Wafer und/oder Filtern kombiniert.

**Patentansprüche**

1. , Vorrichtung zum Bestimmen der Temperatur eines Substrats (W), insbesondere eines Halbleiterwafers während seiner Erwärmung, die folgendes aufweist:

   - wenigstens eine erste Strahlungsquelle (8) zum Erwärmen des Substrats;
   - einen ersten Strahlungsdetektor (20), der derart auf einen zu der wenigstens einen Strahlungsquelle weisenden ersten Oberflächenbereich (20a) des Substrats (W) gerichtet ist, dass vom Substrat stammende Strahlung und ein erster Anteil von am Substrat reflektierter Strahlung der wenigstens einen Strahlungsquelle (8) auf den ersten Strahlungsdetektor (20) fällt, aber im Wesentlichen keine direkt von der wenigstens einen Strahlungsquelle (8) kommende Strahlung;
   - einen zweiten Strahlungsdetektor (21), der derart auf einen zu der wenigstens einen Strahlungsquelle weisenden zweiten Oberflächenbereich (21a) des Substrats (W) gerichtet ist, dass vom Substrat stammende Strahlung und ein zweiter Anteil von am Substrat reflektierter Strahlung der wenigstens einen Strahlungsquelle (8) auf den zweiten Strahlungsdetektor (21) fällt, aber im Wesentlichen keine direkt von der wenigstens einen Strahlungsquelle (8) kommende Strahlung, wobei der erste und zweite Anteil der am Substrat reflektierten Strahlung der wenigstens einen Strahlungsquelle (8), die auf den jeweiligen Strahlungsdetektor (20, 21) fallen, unterschiedlich sind, wobei der erste und zweite Strahlungsdetektor im Wesentlichen die gleiche Substrat-Strahlung messen, und wobei die ersten und zweiten Oberflächenbereiche (20a, 21a) Substratbereiche mit im Wesentlichen dergleichen Temperatur sind; und
   - eine Temperaturbestimmungseinheit, die konfiguriert ist, die Temperatur des Substrats (W) direkt anhand einer Ansteuerleistung oder Strahlungsintensität der ersten Strahlungsquelle (8) und der vom ersten und zweiten Strahlungsdetektor (20, 21) detektierten Strahlung zu ermitteln.

2. . Vorrichtung nach Anspruch 1, die ferner folgendes aufweist:

   - einen dritten Strahlungsdetektor (25), der auf wenigstens eine erste Strahlungsquelle (8) gerichtet ist, um die von der ersten Strahlungsquelle ausgehende Strahlungsintensität zu bestimmen.

3. . Vorrichtung nach einem der vorhergehenden Ansprüche, wobei die ersten und zweiten Oberflächenbereiche (20a, 21a) im Wesentlichen auf einem gemeinsamen Drehkreis zu einem Mittelpunkt des Substrats (W) liegen, und/oder unmittelbar benachbart zueinander liegen oder sich wenigstens teilweise überlappen.

4. . Vorrichtung nach einem der vorhergehenden Ansprüche, die bevorzugt zwischen Substrat und wenigstens einem Strahlungsdetektor (20, 21) wenigstens ein optisches Element aufweist, das den Anteil der am Substrat reflektierten Strahlung der wenigstens einen Strahlungsquelle beeinflusst.

5. . Vorrichtung nach Anspruch 4, wobei das wenigstens eine optische Element eine Blende und/oder ein Filter ist.

6. . Vorrichtung nach Anspruch 4 oder 5, wobei jedem Strahlungsdetektor (20, 21) wenigstens ein optisches Element zugeordnet ist, wobei die optischen Elemente unterschiedliche Öffnungswinkel für ein Sichtfeld des jeweiligen Strahlungsdetektors (20, 21) bilden und/oder mit unterschiedlichen Abständen zum Substrat positioniert sind, um den Anteil der am Substrat reflektierten Strahlung der wenigstens einen Strahlungsquelle (8) am jeweiligen Strahlungsdetektor (20, 21) zu beeinflussen.

7. . Vorrichtung nach einem der vorhergehenden Ansprüche, die wenigstens einen Filter aufweist, der zwischen wenigstens einer Strahlungsquelle (8) aus einer Vielzahl von ersten Strahlungsquellen (8) und dem Substrat (W) angeordnet ist, um aus der Strahlung der wenigstens einen Strahlungsquelle (8) die Strahlung herauszufiltern, die im Bereich der Messwellenlänge des Strahlungsdetektors (20, 21) liegt, bevor die Strahlung der wenigstens einen Strahlungsquelle (8) auf das Substrat fällt (W).

8. . Vorrichtung nach einem der vorhergehenden Ansprüche, wobei die wenigstens eine erste Strahlungsquelle (8) eine Lampe, insbesondere eine Stablampe aufweist.

**9.** . Verfahren zum thermischen Behandeln von Substraten (W), insbesondere Halbleiterwafern, mit folgenden Verfahrensschriften:

- Erwärmen des Substrats (W) mit wenigstens einer ersten Strahlung, die von wenigstens einer ersten Strahlungsquelle (8) ausgeht, wobei Strahlung der ersten Strahlungsquelle (8) auf eine erste Seite des Substrats (W) gerichtet ist und wenigstens teilweise daran reflektiert wird
- Detektieren einer von einem ersten Oberflächenbereich (20a) der ersten Seite des Substrats (W) kommenden ersten Strahlung, wobei die detektierte erste Strahlung wenigstens einen ersten Substrat-Strahlungsanteil und einen ersten Reflektions-Strahlungsanteil aufweist, aber im Wesentlichen keine direkt von der ersten Strahlungsquelle (8) kommende Strahlung, wobei der erste Substrat-Strahlungsanteil aus vom Substrat (W) aufgrund der Eigentemperatur emittierter Strahlung besteht und der erste Reflektions-Strahlungsanteil aus am Substrat (W) reflektierter Strahlung der wenigstens einen ersten Strahlungsquelle (8) besteht,
- Detektieren einer von einem zweiten Oberflächenbereich (21a) der ersten Seite des Substrats (W) kommenden zweiten Strahlung, wobei die detektierte zweite Strahlung wenigstens einen zweiten Substrat-Strahlungsanteil und einen zweiten Reflektions-Strahlungsanteil aufweist, aber im Wesentlichen keine direkt von der ersten Strahlungsquelle (8) kommende Strahlung, wobei der zweite Substrat-Strahlungsanteil aus vom Substrat (W) aufgrund der Eigentemperatur emittierter Strahlung besteht und der zweite Reflektions-Strahlungsanteil aus am Substrat (W) reflektierter Strahlung der wenigstens einen ersten Strahlungsquelle (8) besteht, wobei der erste und der zweite Oberflächenbereich (20a, 21a) Bereiche im Wesentlichen gleicher Temperatur des Substrats (W) sind, wobei der erste und zweite Strahlungsdetektor im Wesentlichen die gleiche Substrat-Strahlung messen, und wobei sich die ersten und zweiten Reflektions-Strahlungsanteile unterscheiden,
- Ermitteln der Temperatur des Substrats (W) auf der Basis der ersten und der zweiten detektierten Strahlungen sowie einer Ansteuerleistung der wenigstens einen ersten Strahlungsquelle (8) und/oder einer Strahlungsintensität derselben.

**10.** . Verfahren nach Anspruch 9, wobei die ersten und zweiten detektierten Strahlungen mit unterschiedlichen Strahlungsdetektoren (20, 21) detektiert werden.

**11.** . Verfahren nach Anspruch 9 oder 10, wobei das Substrat (W) um eine im Wesentlichen senkrecht zur ersten Seite stehenden Achse gedreht wird und die ersten und zweiten Oberflächenbereiche im Wesentlichen auf einem gemeinsamen Drehkreis zu einem Mittelpunkt des Substrats (W) liegen.

**12.** . Verfahren nach einem der Ansprüche 9 bis 11, wobei die ersten und zweiten Oberflächenbereiche unmittelbar benachbart zueinander liegen oder sich wenigstens teilweise überlappen.

**13.** . Verfahren nach einem der Ansprüche 9 bis 12, wobei der erste und/oder zweite Reflektions-Strahlungsanteil durch wenigstens ein optisches Element zwischen Substrat (W) und einem Strahlungsdetektor(20, 21) zum Detektieren der detektierten Strahlung beeinflußt wird.

**14.** . Verfahren nach einem der Ansprüche 9 bis 13, wobei im Strahlengang zwischen wenigstens einer Strahlungsquelle (8) aus einer Vielzahl von ersten Strahlungsquellen (8) und dem Substrat Strahlung im Bereich der Messwellenlänge des Strahlungsdetektors herausgefiltert wird, bevor die Strahlung der wenigstens einen Strahlungsquelle (8) auf das Substrat (W) fällt, um dadurch den detektierten Reflektions-Strahlungsanteil zu beeinflussen.

**15.** , Verfahren nach einem der Ansprüche 9 bis 14, wobei mit einem Strahlungsdetektor (25), der auf die wenigstens eine erste Strahlungsquelle (8) gerichtet ist, die von der wenigstens einen Strahlungsquelle (8) kommende Strahlungsintensität detektiert wird, wobei das Ergebnis dieser Detektion in die Ermittlung der Temperatur des Substrats (W) eingeht.

## Claims

**1.** An apparatus for determining the temperature of a substrate (W), in particular of a semiconductor substrate during its heating, the apparatus comprising:

- at least one first radiation source (8) for heating the substrate;
- a first radiation detector (20), which is directed onto a first surface area (20a) of the substrate (W), which surface area faces towards the at least one radiation source (8), such that radiation emitted by the substrate and a first proportion of radiation of the at least one radiation source (8), which is reflected at the substrate, falls onto the first radiation detector (20, but in substance no radiation stemming directly from the at least one radiation source (8),

- a second radiation detector (21), which is directed onto a second surface area (21a) of the substrate (W), which second surface area faces to the at least one radiation source, such that radiation emitted by the substrate and a second proportion of radiation of the at least one radiation source (8), which is reflected at the substrate, falls onto the second radiation detector (21), but in substance no radiation stemming directly from the at least one radiation source (8), wherein the first and second proportions of the radiation of the first radiation source (8), which is reflected at the substrate, which fall onto the respective radiation detectors (20, 21), are different, wherein the first and second radiation detectors detect in substance the same substrate-radiation, and wherein the first and second surface areas (20a, 21a) are substrate areas having in substance the same temperature; and

- a temperature determination unit, which is configured to determine the temperature of the substrate (W) directly based on a drive power or radiation intensity of the first radiation source (8) and the radiation detected by the first and second radiation detectors (20, 21).

2. The apparatus of claim 1, further comprising:

- a third radiation detector (25), which is directed onto the at least one first radiation source (8), in order to determine the radiation intensity of the first radiation source.

3. The apparatus of any of the preceding claims, wherein the first and second surface areas (20a, 21a) are arranged in substance on a common circle of rotation with respect to a center point of the substrate (W), and/or are arranged directly adjacent to each other or at least partially overlap.

4. The apparatus of any of the preceding claims, further comprising at least one optical element, which influences the proportion of the radiation of the at least one radiation source, which is reflected at the substrate, wherein the at least one optical element is preferably arranged between the substrate and at least one of the radiation detectors (20, 21).

5. The apparatus of claim 4 wherein the at least one optical element is at least one of an aperture and a filter.

6. The apparatus of claim 4 or 5, wherein at least one optical element is allocated to each radiation detector (20, 21), wherein the optical elements define different opening angles for a field of view of the radiation detectors (20, 21) and/or are arranged at different distances from the substrate, in order to influence the proportion of the radiation of the at least one radiation source (8) which is reflected at the substrate and reaches the respective radiation detector (20, 21).

7. The apparatus of any of the preceding claims, comprising at least one filter, which is arranged between at least one radiation source (8) of a plurality of first radiation sources (8) and the substrate (W), in order to filter out the radiation of the at least one radiation source (8), which is within the range of the measurement wave length of the radiation detector (20, 21), before the radiation of the at least one radiation source (8) impinges upon the substrate (W).

8. The apparatus of any of the preceding claims, wherein the at least one first radiation source (8) is a lamp, in particular a rod lamp.

9. A method for thermally treating substrates (W), in particular semiconductor wafers, the method comprising the following steps:

- heating the substrate (W) by means of a first radiation, which is emitted by at least one first radiation source (8), wherein the radiation of the first radiation source (8) is directed onto a first side of the substrate (W) and is at least partially reflected thereby,

- detecting a first radiation coming from a first surface area (20a) of the first side of the substrate (W), wherein the detected first radiation comprises at least a first substrate-radiation portion and a first reflection-radiation portion, but in substance no radiation stemming directly from the at least one radiation source (8), wherein the first substrate-radiation portion consists of radiation emitted by the substrate (W) due to its own temperature, and wherein the first reflection-radiation portion consists of radiation of the first radiation source (8), which is reflected at the substrate (W),

- detecting a second radiation, which comes from a second surface area (21a) of the first side of the substrate (W), wherein the detected second radiation comprises at least a second substrate-radiation portion and a second reflection-radiation portion, but in substance no radiation stemming directly from the at least one radiation source (8), wherein the second substrate-radiation portion consists of radiation emitted by the substrate (W) due to its own temperature and the second reflection-radiation portion consists of radiation of the at least one first radiation source (8) which is reflected at the substrate (W), wherein the first and second surface areas (20a, 21a) are areas which comprise in substance the same temperature of the substrate (W), wherein the first and second radiation detectors detect in substance the same substrate-radiation, and wherein the first and second reflection-radiation portions differ,
- determining the temperature of the substrate (W) on the basis of the first and the second detected radiations and at least one of the drive power of the at least one first radiation source (8) and a radiation intensity of the at least one radiation source (8).

10. The method of claim 9, wherein the first and second radiations are detected with different radiation detectors (20, 21).

11. The method of claim 9 or 10, wherein the substrate (W) is rotated around an axis extending in substance perpendicular to the first side, wherein the first and second surface areas are located in substance on a common circle of rotation with respect to a center point of the substrate (W).

12. The method of any one of claims 9 to 11, wherein the first and second surface areas are directly adjacent to each other or at least partially overlap.

13. The method of any one of claims 9 to 12, wherein at least one of the first and second reflection-radiation portions is influenced by at least one optical element located between the substrate (W) and a radiation detector (20, 21) for detecting the reflected radiation.

14. The method of any one of claims 9 to 13, wherein radiation in the range of the measuring wave length of the radiation detector is filtered out in the radiation path between the at least one radiation source (8) of a plurality of first radiation sources (8) and the substrate, before the radiation of the at least one radiation source (8) falls onto the substrate (W), in order to influence the respective detected reflection-radiation portion.

15. The method of any one of claims 9 to 14, wherein the radiation intensity coming from the at least one radiation source (8) is detected using a radiation detector (25), which is directed onto the at least one first radiation source (8), wherein the result of this detection is used when determining the temperature of the substrate (W).

**Revendications**

1. Dispositif de détermination de la température d'un substrat (W), en particulier d'une tranche semiconductrice pendant son chauffage, le dispositif comprenant :

- au moins une première source de rayonnement (8) pour chauffer le substrat ;
- un premier détecteur de rayonnement (20), qui est dirigé vers une première région de surface (20a) du substrat (W), cette région de surface faisant face à l'au moins une source de rayonnement (8), de sorte que le rayonnement émis par le substrat et une première proportion du rayonnement de l'au moins une source de rayonnement (8), qui est réfléchie au niveau du substrat, tombe sur le premier détecteur de rayonnement (20), mais essentiellement aucun rayonnement ne provenant directement de l'au moins une source de rayonnement (8),
- un deuxième détecteur de rayonnement (21) qui est dirigé vers une deuxième région de surface (21a) du substrat (W), cette deuxième région de surface faisant face à l'au moins une source de rayonnement, de sorte que le rayonnement émis par le substrat et une deuxième proportion du rayonnement de l'au moins une source de rayonnement (8), qui est réfléchie au niveau du substrat, tombe sur le deuxième détecteur de rayonnement (21), mais essentiellement aucun rayonnement ne provenant directement de l'au moins une source de rayonnement (8), dans lequel les première et deuxième proportions du rayonnement de la première source de rayonnement (8), qui est réfléchi au niveau du substrat, qui tombent sur les détecteurs de rayonnement respectifs (20, 21) sont différentes, dans lequel les premier et deuxième détecteurs de rayonnement détectent essentiellement le même rayonnement provenant du substrat, et dans lequel les première et deuxième régions de surface (20a, 21a) sont des régions de substrat ayant essentiellement la même température ; et
- une unité de détermination de température qui est configurée pour déterminer la température du substrat (W) directement sur la base d'une puissance d'alimentation ou d'une intensité de rayonnement de la première source de rayonnement (8) et du rayonnement détecté par les premier et deuxième détecteurs de rayonnement (20, 21).

2. Dispositif selon la revendication 1, comprenant en outre :

- un troisième détecteur de rayonnement (25) qui est dirigé vers l'au moins une première source de rayonnement (8) afin de déterminer l'intensité de rayonnement de la première source de rayonnement.

3. Dispositif selon l'une quelconque des revendications précédentes, dans lequel les première et deuxième régions de surface (20a, 21a) sont agencées essentiellement sur un cercle de rotation commun vers un point central du substrat (W), et/ou sont agencées directement adjacentes ou se chevauchent au moins partiellement.

4. Dispositif selon l'une quelconque des revendications précédentes, comprenant en outre au moins un élément optique qui influence la proportion du rayonnement de l'au moins une source de rayonnement qui est réfléchie au niveau du substrat, dans lequel l'au moins un élément optique est de préférence agencé entre le substrat et au moins un des détecteurs de rayonnement (20, 21).

5. Dispositif selon la revendication 4, dans lequel l'au moins un élément optique est au moins un parmi une ouverture et un filtre.

6. Dispositif selon la revendication 4 ou 5, dans lequel au moins un élément optique est associé à chaque détecteur de rayonnement (20, 21), dans lequel les éléments optiques définissent différents angles d'ouverture pour un champ de vision des détecteurs de rayonnement (20, 21) et/ou sont agencés à différentes distances du substrat, afin d'influencer la proportion du rayonnement de l'au moins une source de rayonnement (8) qui est réfléchie au niveau du substrat et atteint le détecteur de rayonnement respectif (20, 21).

7. Dispositif selon l'une quelconque des revendications précédentes, comprenant au moins un filtre qui est agencé entre au moins une source de rayonnement (8) d'une pluralité de premières sources de rayonnement (8) et le substrat (W) afin d'éliminer par filtrage le rayonnement de l'au moins une source de rayonnement (8), qui est dans la plage de la longueur d'onde de mesure du détecteur de rayonnement (20, 21), avant que le rayonnement de l'au moins une source de rayonnement (8) ne frappe le substrat (W).

8. Dispositif selon l'une quelconque des revendications précédentes, dans lequel l'au moins une première source de rayonnement (8) est une lampe, en particulier une lampe-torche.

9. Procédé de traitement thermique de substrats (W), en particulier de tranches semiconductrices, comprenant les étapes suivantes :

- le chauffage du substrat (W) au moyen d'un premier rayonnement, qui est émis par au moins une première source de rayonnement (8), dans lequel le rayonnement de la première source de rayonnement (8) est dirigé vers un premier côté du substrat (W) et est au moins partiellement réfléchi sur celui-ci,
- la détection d'un premier rayonnement provenant d'une première région de surface (20a) du premier côté du substrat (W), dans lequel le premier rayonnement détecté comprend au moins une première partie de rayonnement provenant du substrat et une première partie de rayonnement de réflexion, mais sensiblement aucun rayonnement ne frappant directement en provenance de l'au moins une première source de rayonnement (8), dans lequel la première partie de rayonnement provenant du substrat consiste en un rayonnement émis par le substrat (W) en raison de sa propre température et dans lequel la première composante de rayonnement de réflexion consiste en un rayonnement de la première source de rayonnement (8) qui est réfléchi au niveau du substrat (W),
- la détection d'un deuxième rayonnement qui provient d'une deuxième région de surface (21a) du premier côté du substrat (W), dans lequel le deuxième rayonnement détecté comprend au moins une deuxième partie de rayonnement provenant du substrat et une deuxième partie de rayonnement de réflexion, mais sensiblement aucun rayonnement ne frappant directement en provenance de l'au moins une source de rayonnement (8), dans lequel la deuxième partie de rayonnement de substrat consiste en un rayonnement émis par le substrat (W) en raison de sa propre température et la deuxième composante de rayonnement de réflexion consiste en un rayonnement de l'au moins une première source de rayonnement (8) qui est réfléchi au niveau du substrat (W), dans lequel les première et deuxième régions de surface (20a, 21a) sont des régions ayant essentiellement la même température que le substrat (W), dans lequel les premier et deuxième détecteurs de rayonnement détectent sensiblement le même rayonnement provenant du substrat et dans lequel les première et deuxième partie de rayonnement de réflexion sont différentes,

- la détermination de la température du substrat (W) sur la base du premier et du deuxième rayonnement détecté et d'au moins une parmi la puissance d'alimentation de l'au moins une première source de rayonnement (8) et une intensité de rayonnement de l'au moins une source de rayonnement (8).

10. Procédé selon la revendication 9, dans lequel les premier et deuxième rayonnements sont détectés avec différents détecteurs de rayonnement (20, 21).

11. Procédé selon la revendication 9 ou 10, dans lequel dans lequel le substrat (W) est mis en rotation autour d'un axe s'étendant sensiblement perpendiculairement au premier côté, dans lequel les première et deuxième régions de surface sont situées sensiblement sur un cercle de rotation commun à un point central du substrat (W).

12. Procédé selon l'une quelconque des revendications 9 à 11, dans lequel les première et deuxième régions de surface (20a, 21a) sont directement adjacentes ou se chevauchent au moins partiellement.

13. Procédé selon l'une quelconque des revendications 9 à 12, dans lequel au moins une des première et deuxième parties de rayonnement de réflexion est influencée par au moins un élément optique situé entre le substrat (W) et un détecteur de rayonnement (20, 21) pour détecter le rayonnement détecté.

14. Procédé selon l'une quelconque des revendications 9 à 13, dans lequel le rayonnement dans la plage de la longueur d'onde de mesure du détecteur de rayonnement est extrait par filtrage du trajet de rayonnement entre l'au moins une source de rayonnement (8) d'une pluralité de premières sources de rayonnement (8) et le substrat, avant que le rayonnement de l'au moins une source de rayonnement (8) ne tombe sur le substrat (W), afin d'influencer la partie de rayonnement de réflexion détectée respective.

15. Procédé selon l'une quelconque des revendications 9 à 14, dans lequel l'intensité de rayonnement provenant de l'au moins une source de rayonnement (8) est détectée en utilisant un détecteur de rayonnement (25) qui est dirigé vers l'au moins une première source de rayonnement (8), dans lequel le résultat de cette détection est utilisé pendant la détermination de la température du substrat (W).

Fig. 1

Fig. 2

Fig. 3

Fig. 4

## Fig. 5

(a) Pyrometersignal 5% Lampenleistung

ε = 0,7
ε = 0,5
ε = 0,3

Pyrometersignal
(beliebige Einheiten)

Wafertemperatur T(°C)

(a)

(b) Pyrometersignal 50% Lampenleistung

ε = 0,7
ε = 0,5
ε = 0,3

Pyrometersignal
(beliebige Einheiten)

Wafertemperatur T(°C)

(b)

Fig. 6

Wafertemperatur $T_p(°C)$

Lampenleistung P (%)

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5318362 A
- WO 2008003080 A2
- US 20020066859 A1
- WO 0047962 A